Europäisches Patentamt

European Patent Office

Office européen des brevets

(19)

(11) Veröffentlichungsnummer: **0 387 686**

**A2**

(12) # EUROPÄISCHE PATENTANMELDUNG

(21) Anmeldenummer: **90104372.9**

(22) Anmeldetag: **07.03.90**

(51) Int. Cl.⁵: **H03M 1/60, H03K 7/06**

(30) Priorität: **17.03.89 DE 3908848**

(43) Veröffentlichungstag der Anmeldung:
**19.09.90 Patentblatt 90/38**

(84) Benannte Vertragsstaaten:
**CH DE ES FR GB IT LI SE**

(71) Anmelder: **Siemens Aktiengesellschaft**
**Wittelsbacherplatz 2**
**D-8000 München 2(DE)**

(72) Erfinder: **Hagen, Hartwig, Dipl.-Ing. FH**
**Paul-Gossen Strasse 34**
**D-8520 Erlangen(DE)**

(54) Verfahren zur Spannungs-Frequenz-Wandlung und Einrichtung zur Durchführung des Verfahrens.

(57) Mit dem Verfahren zur Spannungs-Frequenz-Wandlung und einer Einrichtung zur Durchführung des Verfahrens läßt sich mit einfachen Mitteln eine äußerst schnelle und hochgenaue Digitalisierung eines Eingangssignals bei großem Frequenzhub erreichen. Eine in den positiven Bereich angehobene Eingangsspannung ($U_E^\pm$) wird integriert und als integrierte Spannung ($U_J$) mit einer in äquidistanten Schritten veränderlichen Referenzspannung ($U_A$) verglichen. Mit der daraus resultierenden Differenzspannung ($U_D$) wird über ein Regelglied (RG) ein spannungsgesteuerter Oszillator (VCO) beaufschlagt, der eine der Ausgangsspannung des Regelgliedes (RG) proportionale Impulsfolgefrequenz abgibt. Mit jedem Impuls (P) wird die Referenzspannung ($U_A$) inkrementiert, so daß diese treppenförmig der integrierten Spannung ($U_J$) folgt. Die Impulsfolgefrequenz der durch den spannungsgesteuerten Oszillator (VCO) erzeugten Impulse (P) ist damit proportional der Eingangsspannung ($U_E$).

EP 0 387 686 A2

FIG 1

# Verfahren zur Spannungs-Frequenz-Wandlung und Einrichtung zur Durchführung des Verfahrens

Die Erfindung bezieht sich auf ein Verfahren zur Spannungs-Frequenz-Wandlung sowie auf eine Einrichtung zur Durchführung des Verfahrens. In der Meßwerterfassung kann in vielen Fällen ein Spannungs-Frequenz-Wandler einen Analog-Digital- oder Digital-Analog-Wandler ersetzen. Ein Spannungs-Frequenz-Wandler gibt anstelle des binärparallelen Codewortes eine der Eingangsspannung proportionale Frequenz an seinem Ausgang ab. Ein Vorteil liegt darin, daß man den analogen Teil einer Schaltung leicht vom digitalen Teil isolieren kann. Deshalb werden Spannungs-Frequenz-Wandler in den verschiedensten Gebieten der Elektrotechnik und Elektronik verwendet. Beispielsweise lassen sich bei der Regelung von Elektromotoren die Strom- bzw. Spannungsistwerte durch Wandlung in eine dem Strom- bzw. Spannungsistwert proportionale Folge von Impulsen leicht in ein digitales Regelungskonzept integrieren.

Zur Einbindung der Spannungs- bzw. Stromistwerterfassung in ein digitales Regelungskonzept ist es wünschenswert, das kontinuierliche Signal bereits am Ort seiner Erfassung in eine proportionale Frequenz zu wandeln und beispielsweise in Form von Impulsen mit unterschiedlicher Impuls-Folgefrequenz zu übertragen. Damit ist eine hohe Störsicherheit gewährleistet, da für die Weiterverarbeitung der Impulse nur geringe Ansprüche an die Impulsform gestellt werden.

Eine wirtschaltliche und dabei aber sehr schnelle und hochgenaue Digitalisierung eines kontinuierlichen Eingangssignals bei großem Frequenzhub kann nicht ausschließlich durch herkömmliche Spannungs-Frequenz-Wandler realisiert werden.

Aufgabe der Erfindung ist es, ein Verfahren und eine Einrichtung zur schnellen, hochgenauen Spannungs-Frequenz-Wandlung bei großem Frequenzhub mit einfachen Mitteln zu realisieren. Diese Aufgabe wird durch ein Verfahren zur Spannungs-Frequenz-Wandlung nach folgenden Verfahrensschritten gelöst:

a) Eine Eingangsspannung, die einen beliebigen zeitlichen Verlauf haben kann, wird durch Verknüpfung mit einer Konstante in den positiven Bereich angehoben,

b) die angehobene Eingangsspannung wird integriert und als integrierte Spannung mit einer Referenzspannung verglichen, die in äquidistanten Schritten veränderlich ist,

c) mit der Spannungsdifferenz zwischen der integrierten Spannung und der Referenzspannung wird über ein Regelglied ein spannungsgesteuerter Oszillator beaufschlagt, der eine der Ausgangsspannung des Regelgliedes proportionale Folge von Impulsen erzeugt,

d) durch jeden Impuls wird die Referenzspannung um einen äquidistanten Spannungshub erhöht, so daß die Spannungsdifferenz gegen Null geht,

e) bei Erreichen eines vorgegebenen oberen Grenzwertes werden die Verfahrensschritte a) bis d) wiederholt, wobei die Integration der angehobenen Eingangsspannung reversiert und die Referenzspannung um einen äquidistanten Spannungshub erniedrigt wird,

f) bei Erreichen eines vorgegebenen unteren Grenzwertes werden die Verfahrensschritte a) bis d) wiederholt,

g) die vom spannungsgesteuerten Oszillator erzeugten Impulse werden in einem Zeitintervall gezählt.

Eine Ausbildung der Erfindung ist dadurch gekennzeichnet, daß aus den erzeugten Impulsen eine Gleichspannung und aus der Gleichspannung sowie aus der angehobenen Eingangsspannung eine Differenzspannung gebildet wird, wobei aus Summe der Differenzspannung und der angehobenen Eingangsspannung eine Regelspannung erzeugt wird, mit der eine jeweils verwendete Integrationseinrichtung beaufschlagt wird.

Diese Ausbildung der Erfindung dient zur Fehlerregelung und kann beispielsweise dann verwendet werden, wenn hohe Anforderungen an die Genauigkeit der Spannungs-Frequenz-Wandlung gestellt werden, oder wenn aus Kostengründen auf weniger leistungsfähige und damit in den meisten Fällen ungenauere Bauteile für eine Einrichtung zur Durchführung des Verfahrens verwendet werden sollen.

Zur Durchführung des Verfahrens bietet sich eine Einrichtung zur Spannungs-Frequenz-Wandlung an wie sie den Ansprüchen 3 bis 5 zugrundeliegt.

Ein Ausführungsbeispiel der Erfindung ist in der Zeichnung dargestellt und wird im folgenden näher erläutert. Dabei zeigen:

FIG 1 ein Blockschaltbild einer Einrichtung zur Spannungs-Frequenz-Wandlung,

FIG 2 ein Blockschaltbild einer Einrichtung zur Spannungs-Frequenz-Wandlung mit Fehlerregelung.

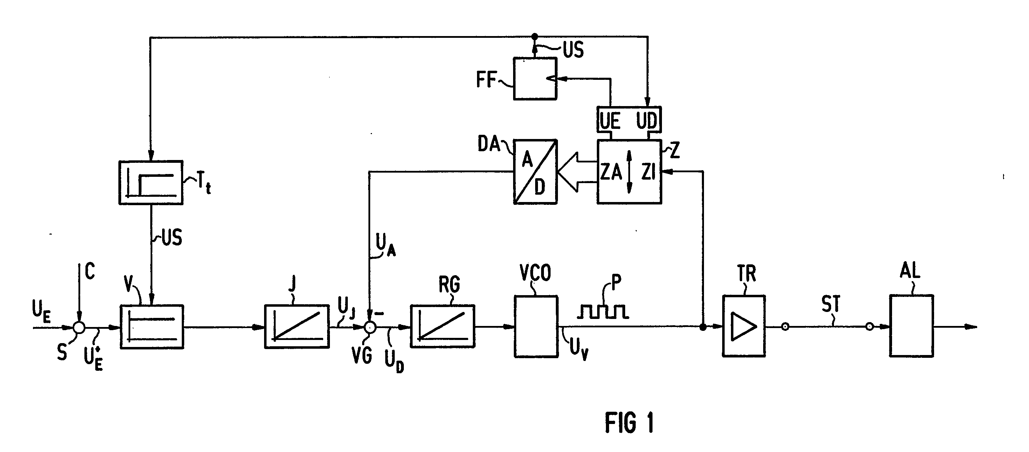

Das Blockschaltbild gemäß FIG 1 zeigt eine Einrichtung zur Spannungs-Frequenz-Wandlung. Die Richtung des Signalflusses im Blockschaltbild ist durch Pfeile angegeben. Damit sind auch die jeweiligen Ein- und Ausgänge eines jeden Blockes festgelegt. Die Einrichtung besteht aus einem Summierer S, einem Verstärker V, einem Integrator J, einem Vergleicher VG, einem Regler RG, einem spannungsgesteuerten Oszillator VCO (Voltage Controlled Oscillator), einer Treiberstufe TR, einer Übertragungsstrecke ST, sowie einer Auswertelogik AL.

Der Summierer S verfügt über zwei Eingänge von denen ein erster Eingang mit einer Eingangsspannung $U_E$ und ein zweiter Eingang mit einer Konstanten C beaufschlagt ist. Die Konstante C ist dabei so berechnet, daß die Eingangsspannung $U_E$ in den positiven Bereich $U_E^{\pm}$ angehoben wird. Die Konstante C könnte aber selbstverständlich auch so berechnet sein, daß die Eingangsspannung $U_E$ in den negativen Bereich transformiert wird. Bei der Transformation der Eingangsspannung $U_E$ kommt es lediglich darauf an, daß über ihren gesamten zeitlichen Verlauf kein Polaritätswechsel stattfindet.

Der Verstärker V weist zusätzlich zu seinem Verstärkereingang, der mit der angehobenen Eingangsspannung $U_E^{\pm}$ beaufschlagt ist, einen weiteren Eingang für ein Umschaltsignal US auf. Über diesen Eingang und mittels des Umschaltsignals US kann der Verstärker auf positive oder negative Verstärkung geschaltet werden.

Der Vergleicher VG und der Regler RG sind der Übersichtlichkeit halber getrennt gezeichnet. Der Vergleicher VG kann jedoch auch integraler Bestandteil des Reglers RG sein, der in diesem Fall zwei Eingänge aufweisen würde.

Der Ausgang des spannungsgesteuerten Oszillators VCO ist mit dem Eingang ZI eines Zählers Z verbunden. Der Zähler Z ist durch einen Doppelpfeil als Auf-Abwärtszähler gekennzeichnet. Der Ausgang ZA des Zählers Z ist mit dem Digitaleingang D eines Digital-Analog-Wandlers DA verbunden, dessen Analogausgang A auf den zweiten Eingang des Vergleichers VG geführt ist.

Zusätzlich zum Zählimpulseingang ZI und zum Zählerausgang ZA verfügt der Zähler Z über einen Zählrichtungs-Umschalteingang UD (up/down) sowie über einen Überlaufsignalausgang UE. Über den Überlaufsignalausgang UE kann ein Signal ausgegeben werden, wenn der Zähler Z eine vorgebbare Zählgrenze erreicht hat. Dieses Überlaufsignal UE wird an den Eingang eines bistabilen Schaltgliedes FF (Flip-Flop) gegeben, an dessen Ausgang das Umschaltsignal US beispielsweise als Binärsignal erscheint.

Legt man an den ersten Eingang des Summierers S eine beliebige - auch bipolare - Eingangsspannung $U_E$, so wird diese durch Verknüpfung mit der vorbestimmten Konstante C in den positiven Bereich angehoben. Die angehobene Eingangsspannung $U_E^{\pm}$ wird an den Eingang des Integrators J gelegt. Es sei angenommen, daß die angehobene Eingangsspannung $U_E^{\pm}$ proportional dem Stromistwert eines Servormotors ist, der zur Regelung des Servomotors verwendet werden soll. Da für die Regelung lediglich der Mittelwert der angehobenen

Eingangsspannung $U_E^{\pm}$ von Interesse ist, wird diese zunächst integriert und als integrierte Spannung $U_J$ an den ersten Eingang des Vergleichers VG gegeben. Am zweiten Eingang des Vergleichers VG liegt gleichzeitig eine Referenzspannung $U_A$ an, die mit der integrierten Spannung $U_J$ verglichen wird.

Zu einem Zeitpunkt t = 0 sei die Referenzspannung sowie die integrierte Spannung gleich Null. Aufgrund der anliegenden Eingangsspannung $U_E$ steigt die integrierte Spannung $U_J$ zur Zeit t größer 0 an.

Damit stellt sich am Ausgang des Vergleichers VG eine Differenzspannung $U_D$ ein, die der Differenz der Referenzspannung $U_A$ und der integrierten Spannung $U_J$ entspricht und für die gilt:
$$U_D = U_J - U_A.$$

Die Differenzspannung $U_D$ ist also positiv, wenn die integrierte Spannung $U_J$ größer ist als die Referenzspannung UA und umgekehrt. Damit entsteht am Ausgang des Reglers RG ein positives bzw. negatives Ausgangssignal, mit dem der spannungsgesteuerte Osziallator VCO beaufschlagt wird.

Der Regler RG ist als schneller Integrator ausgebildet, weil mit I-Reglern zum einen keine bleibenden Regelabweichungen auftreten (Genauigkeit), zum anderen die Totzeiten des Systems (VCO, Zähler, DA-Wandler) beherrschbar sind. Der I-Regler wird um so schneller in die entsprechende Richtung integrieren, je größer die Regelabweichung $U_D$ ist. Ist $U_D$ = 0, behält der Reglerausgang seinen letzten Wert.

Selbstverständlich bleibt es dem Fachmann überlassen, einen einfacheren Regler, beispielsweise einen P-Regler, zu verwenden, wenn die Anforderungen an die Qualität der Regelung gering sind. Für höhere Anforderungen könnte auch ein PI-Regler oder ein Regelglied höherer Ordnung verwendet werden.

Der spannungsgesteuerte Oszillator VCO erzeugt ein Ausgangssignal $U_V$ in Form eines Pulspausensignals P dessen Impulsfolgefrequenz proportional zum Ausgang des Regler RG ist.

Das Ausgangssignal $U_V$ des spannungsgesteuerten Oszillators VCO - d.h. ein jeweiliger Impuls P - gelangt außer an den Treiber TR auch an den Zählimpulseingang ZI des Zählers Z. Mit jedem Impuls P wird der Zähler Z um einen Zählschritt weitergeschaltet, worauf am Ausgang A des Digital-Analog-Wandlers DA die Referenzspannung $U_A$ um einen äquidistanten Spannungshub erhöht wird. Damit ist die Referenzspannung $U_A$ größer als die integrierte Spannung $U_J$.

Je größer die Differenzspannung $U_D$, desto schneller erhöht der Regler die Impulsfolgefrequenz des spannungsgesteuerten Oszillators VCO. Eine schnelle Erhöhung der Impulsfolgefrequenz führt dazu, daß die Referenzspannung $U_A$ über den Zähler Z und den Digital-Analog-Wandler DA rasch in den vorgegebenen äquidistanten Schritten ansteigt, und so die integrierte Spannung wieder "einholt". Damit ist erreicht, daß die Impulsfolgefrequenz des spannungsgesteuerten Oszillators proportional zur Eingangsspannung $U_E$ ist.

Im Beispiel gemäß FIG 1 werden die Impulse P über eine Treiberstufe TR und eine Übertragungsstrecke ST an eine Auswertelogik AL gegeben. An die Übertragungsstrecke ST werden dabei keine hohen Anforderungen gestellt. Die Übertragung einer hohen Impulsfolgefrequenz (beispielsweise 20 MHz) ist unkritisch, da an die Impulsform nur geringe Ansprüche gestellt werden, so daß die Qualität des Verfahrens nicht beeinträchtigt wird, solange die Impulse P von der Auswertelogik AL gerade noch erkannt werden können. Falls tatsächlich ein Impuls nicht mehr erkannt werden sollte, entsteht kein bleibender Fehler, da lediglich die Genauigkeit einer Zählung innerhalb des vorgegebenen Zeitintervalls beeinflußt wird. Insofern weist das Verfahren eine hohe Störsicherheit auf.

Die Impulsfolgefrequenz des Spannungs-Frequenz-Wandlers kann leicht ausgewertet werden, in dem sie in einem Zähler der in der Auswertelogik AL integriert sein kann, (z.B. 16 Bitzähler) aufsummiert wird. Dieser Zähler kann Bestandteil einer digitalen Regeleinrichtung sein, so daß das Ergebnis der Spannungs-Frequenz-Wandlung unmittelbar für die Regelung herangezogen werden kann. Die nachfolgende Verarbeitung der Impulsfolgefrequenz kann freizügig variieren in Bezug auf die Wahl der Abtastzeitpunkte und verschiedene Arten der Mittelwertbildung. Vorteilhafterweise könnte die Mittelwertbildung über ein sogenanntes gleitendes Fenster erfolgen. Dabei wird die Anzahl der Impulse in einem Zeitintervall T gezählt, wobei die Zählung periodisch in einem kürzeren Zeitintervall als dem Zeitintervall T wiederholt wird.

Bei der bisherigen Beschreibung der Wirkungsweise der Spannungs-Frequenz-Wandlung wurde von der idealen Annahme ausgegangen, daß sowohl der Integrator J als auch der Zähler Z und der Digital-Analog-Wandler DA keine oberen Grenzwerte aufweisen. Dies ist bei realen Bauteilen natürlich nicht der Fall. Es müssen deshalb Maßnahmen getroffen werden, die die Funktion des Verfahrens auch dann gewährleisten, wenn der Integrator J, oder der Zähler Z, oder der Digital-Analog-Wandler DA an ihre obere oder untere Grenze stoßen.

Der obere Grenzwert des Zählers Z ist so vorzugeben, daß er erreicht wird, bevor der Integrator J seine obere physikalische Integrationsgrenze erreicht hat. Selbstverständlich ist auch der Digital-Analog-Wandler DA so auszulegen, daß er für den gesamten vorgegebenen Zählbereich des Zählers Z geeignet ist.

Die Integration der angehobenen Eingangsspannung $U_E^{\pm}$ sowie die Weiterschaltung der Referenzspannung $U_A$ über den Zähler Z und den Digital-Analog-Wandler DA erfolgt solange, bis der Zähler Z seinen vorgegebenen oberen Grenzwert erreicht hat. Mit Erreichen dieses oberen Grenzwertes wird über den Überlaufausgang UE des Zählers Z das Überlaufsignal an den bistabilen Schalter FF gegeben, der daraufhin an seinem Ausgang den Binärzustand wechselt. Dieser Wechsel des Binärzustandes gelangt als Umschaltsignal US unmittelbar an den Umschalteingang UD des Zählers Z. Damit wird die Zählerumschaltung herbeigeführt. Der Zähler wird also ab dem nächsten Zählimpuls von seinem oberen Grenzwert in äquidistanten Schritten abwärts zählen. Die Integrationsrichtung des Integrators ändert sich zu diesem Zeitpunkt noch nicht, da das Umschaltsignal über ein Totzeitglied $T_t$ zeitverzögert an den Verstärker V gelangt. Mit dem Totzeitglied $T_t$ wird die Totzeit des Digital-Analog-Wandlers kompensiert. Dadurch wird der Verstärker V erst dann umgeschaltet, wenn der Digital-Analog-Wandler-Ausgang, bedingt durch den Richtungswechsel des Zählers, ebenfalls die Richtung gewechselt hat. Die Totzeit $T_t$ kann dabei so vorgegeben werden, daß sie der Totzeit des eingesetzten Wandlertyps entspricht.

Nach Ablauf der vorgegebenen Totzeit wird die Verstärkung des Verstärkers V durch das Umschaltsignal US umgeschaltet, d.h. der Verstärker arbeitet jetzt mit negativer Verstärkung. Damit kehrt sich ebenfalls die Integrationsrichtung des Integrators J um.

Wenn der Zähler wieder seine untere Grenze erreicht hat, wird wieder über den Umschaltausgang UE des Zählers Z der bistabile Schalter FF angesteuert, dessen binäres Ausgangssignal wieder wechselt und als Umschaltsignal US zunächst die Zählrichtung des Zählers umsteuert, um dann den Verstärker V wieder auf positive Verstärkung zu schalten, wobei das Verfahren von vorne beginnt.

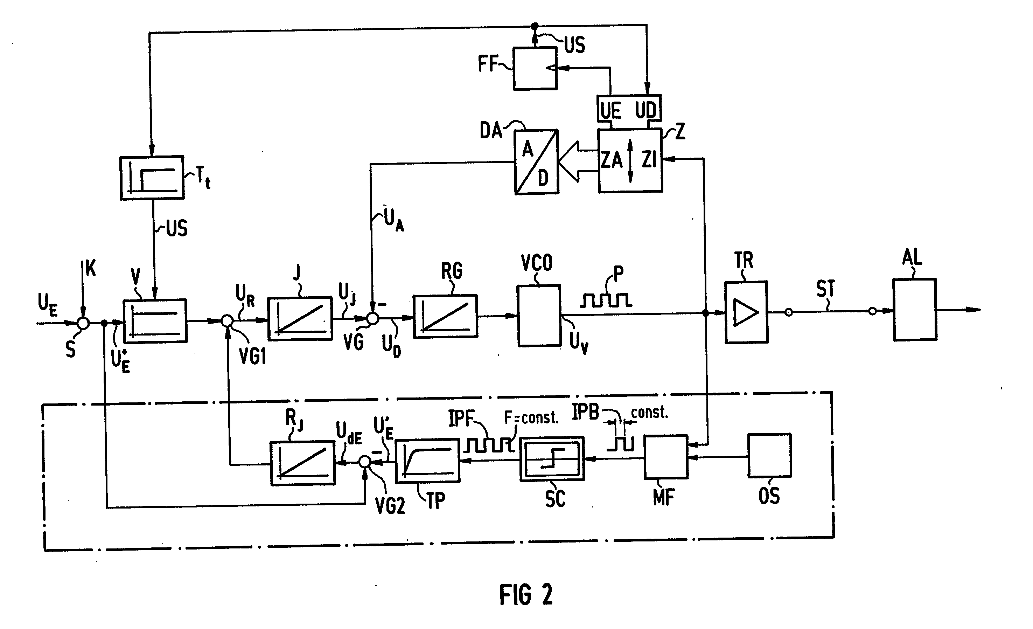

Die Betriebssicherheit des Spannungs-Frequenz-Wandlers, die beispielsweise durch die Güte der Bauteile beeinflußt wird, läßt sich durch eine Fehlerregelung, wie sie im folgenden anhand der FIG 2 beschrieben ist, weiter verbessern.

FIG 2 zeigt ein Blockschaltbild einer Einrichtung zur Spannungs-Frequenz-Wandlung mit Fehlerregelung. Die Regelstrecke für die Fehlerregelung ist durch ein gestrichelt gezeichnetes Rechteck hervorgehoben. Der übrige Teil des Blockschaltbildes entspricht bis auf einen Vergleicher VG1 zwischen dem Verstärker V und dem Integrierer J, dem bereits aus FIG 1 bekannten Blockschaltbild.

Die Regelstrecke zur Fehlerregelung besteht - von rechts nach links - aus einem Oszillator OS, einem monostabilen Schalter MF (Monoflop), einem Präzisionsschalter SC, einem Tiefpaß TP, einem zweiten Vergleicher VG2, und einem Regler $R_J$. Das Monoflop MF bildet zusammen mit dem Oszillator OS ein sogenanntes Präzisions-Monoflop.

An den Eingang des Monoflops MF gelangen die vom spannungsgesteuerten Oszillator VCO erzeugten Impulse P. Bei jedem dieser ankommenden Impulse P greift sich das Monoflop MF genau eine Periode des Oszillators OS heraus und erzeugt einen Präzisionsimpuls IPB mit jeweils konstanter Impulsbreite. Die Präzisionsimpulse IPB werden an den Eingang des Präzisionsschalters SC gegeben. Der Präzisionsschalter SC gibt die ankommenden Präzisionsimpulse IPB mit genau definierter Spannung an seinen Ausgang. Das Präzisions-Monoflop MF, OS und der Präzisionsschalter SC erzeugen also einen Präzisionsimpuls IPF mit genau definiertem konstantem Flächeninhalt. Dieser Präzisionsimpuls wird an den Eingang des Tiefpasses TP gegeben, an dessen Ausgang nunmehr eine der Pulsfolgefrequenz proportionale Gleichspannung $U_E^!$ erscheint, die bei idealer Spannungs-Frequenz-Wandlung gleich der angehobenen Eingangsspannung $U_E^+$ sein müßte. Diese Gleichspannung $U_E^!$ wird am Vergleicher VG2 mit der angehobenen Eingangsspannung $U_E^+$ verglichen und die dabei entstehende Differenzspannung $U_{dE}$ wird über einen Regler $R_J$ dem Vergleicher VG1 der Regelstrecke aufgeschaltet. Am Ausgang des Vergleichers VG1 entsteht damit eine Regelspannung $U_R$ aus der Differenz der Differenzspannung $U_{dE}$ und der angehobenen und verstärkten Eingangsspannung $U_E^+$.

Mit dieser Fehlerregelung arbeitet das Verfahren bzw. die Einrichtung auch dann noch mit ausreichender Genauigkeit, wenn Bauteile geringerer Güte verwendet werden.

## Ansprüche

1. Verfahren zur Spannungs-Frequenz-Wandlung nach folgenden Verfahrensschritten:

a) Eine Eingangsspannung ($U_E$), die einen beliebigen zeitlichen Verlauf haben kann, wird durch Verknüpfung mit einer Konstante (C) in den positiven Bereich angehoben,

b) die angehobene Eingangsspannung ($U_E^+$) wird integriert und als integrierte Spannung ($U_J$) mit einer Referenzspannung ($U_A$) verglichen, die in äquidistanten Schritten veränderlich ist,

c) mit der Spannungsdifferenz ($U_D$) zwischen der integrierten Spannung ($U_J$) und der Referenzspannung ($U_A$) wird über ein Regelglied (RG) ein spannungsgesteuerter Oszillator (VCO) beaufschlagt, der eine der Ausgangsspannung des Regelglieds (RG) proportionale Folge von Impulsen (P) erzeugt,

d) durch jeden Impuls (P) wird die Referenzspannung ($U_A$) um einen äquidistanten Spannungshub erhöht, so daß die Spannungsdifferenz ($U_D$) gegen Null geht,

e) bei Erreichen eines vorgegebenen oberen Grenzwertes werden die Verfahrensschritte a) bis d) wiederholt, wobei die Integration der angehobenen Eingangsspannung ($U_E^+$) reversiert und die Referenzspannung ($U_A$) um einen äquidistanten Spannungshub erniedrigt wird,

f) bei Erreichen eines vorgegebenen unteren Grenzwertes werden die Verfahrensschritte a) bis d) wiederholt,

g) die vom spannungsgesteuerten Oszillator (VCO) erzeugten Impulse (P) werden in einem Zeitintervall (T) gezählt.

2. Verfahren nach Anspruch 1, **dadurch gekennzeichnet,** daß aus den erzeugten Impulsen (P) eine Gleichspannung ($U_E^!$) und aus der Gleichspannung ($U_E^!$) sowie aus der angehobenen Eingangsspannung ($U_E^+$) eine Differenzspannung ($U_{dE}$) gebildet wird, wobei aus der Summe der Differenzspannung ($U_{dE}$) und der angehobenen Eingangsspannung ($U_E^+$) eine Regelspannung ($U_R$) erzeugt wird, mit der eine jeweils verwendete Integrationseinrichtung (J) beaufschlagt wird.

3. Einrichtung zur Spannungs-Frequenz-Wandlung bestehend aus:

a) Einem Verstärker (V) mit umschaltbarer positiver und negativer Verstärkung, die jeweils durch ein Umschaltsignal (US) auslösbar ist, wobei der Ausgang des Verstärkers (V) mit dem Eingang eines Integrators (J) verbunden ist,

b) einem Vergleicher (VG) dessen erster Eingang mit dem Ausgang des Integrators (J), dessen zweiter Eingang mit dem Analogausgang (A) eines Digital-Analog-Wandlers (DA) und dessen Ausgang mit dem Eingang eines Reglers (RG) verbunden ist,

c) einem spannungsgesteuerten Oszillator (VCO), der dem Regler (RG) nachgeschaltet ist und der Impulse (P) erzeugt, wobei die Impulsfolgefrequenz von seinem Eingangssignal ($U_D$) abhängig ist,

d) einer Auswertelogik (AL), die mit dem Ausgang des spannungsgesteuerten Oszillators (VCO) verbunden ist, welche die Impulse (P) in einem bestimmten Zeitintervall (T) zählt, wobei die Summe der Impulse (P) pro Zeitintervall (T) am Ausgang der Auswertelogik (AL) abgreifbar ist,

e) einem in der Zählrichtung umschaltbaren Zähler (Z), dessen Zählimpulseingang (ZI) mit dem Ausgang des spannungsgesteuerten Oszillators (VCO) und dessen Zählerausgang (ZA) mit dem Digitaleingang (D) des Digital-Analog-Wandlers (DA) verbunden ist, wobei der Zähler (Z) über einen Überlaufausgang (UE) ein Überlaufsignal ausgibt, wenn jeweils eine vorgebbare obere oder untere Zählgrenze erreicht ist,

f) einem bistabilen Schalter (FF), der bei jedem Überlaufsignal des Zählers (Z) ein Umschaltsignal (US) abgibt, indem er sein binäres Ausgangssignal wechselt, wobei das Umschaltsignal (US) die Umschaltung zwischen positiver und negativer Verstärkung des Verstärkers (V), sowie die Umschaltung der Zählrichtung des Zählers (Z) über dessen Umschalteingang (UD), bewirkt.

4. Einrichtung nach Anspruch 3, **dadurch gekennzeichnet,** daß die vom spannungsgesteuerten Oszillator (VCO) erzeugten Pulse (P) über eine Regelstrecke in eine Gleichspannung zurückgewandelt werden, bestehend aus:

a) einem monostabilen Präzisionsschalter (MF) der über einen Oszillator (OS) gesteuert wird und der zu jedem Impuls (P) einen Präzisionsimpuls (IPB) mit konstanter Pulsbreite erzeugt,

b) einem Schalter (SC) der die vom monostabilen Präzisionsschalter (MF) ankommenden Präzisionsimpulse (IPB) als Präzisionsimpulse (IPF) mit konstantem Flächeninhalt an einen Tiefpaß (TP) weitergibt,

c) einem Vergleicher (VG2) der eine Differenzspannung ($U_{dE}$) aus der Gleichspannung ($U_E^{\shortmid}$) am Ausgang des Tiefpasses (TP) und aus der angehobenen Eingangsspannung ($U_E^{\pm}$) bildet,

d) einem Regler ($R_J$) der die Differenzspannung ($U_{dE}$) regelt und

e) einem Vergleicher (VG1) zwischen dem Ausgang des Verstärkers (V) und der verbleibenden Regelstrecke des Spannungs-Frequenz-Wandlers, der aus der Summe der verstärkten angehobenen Eingangsspannung ($U_E^{\pm}$) am Ausgang des Verstärkers (V) und aus der geregelten Differenzspannung ($U_{dE}$) am Ausgang des Reglers ($R_J$) eine Regelgröße ($U_R$) für die verbleibende Regelstrecke des Spannungs-Frequenz-Wandlers bildet.

5. Einrichtung nach Anspruch 3 oder 4, wobei die Auswertelogik (AL) über eine Übertragungsstrecke (ST) und eine Treiberstufe (TR) an die verbleibende Einrichtung angeschlossen ist.

FIG 1

EP 0 387 686 A2

FIG 2

EP 0 387 686 A2